(19) Europäisches Patentamt
European Patent Office
Office européen des brevets

(11) EP 2 913 605 A1

(12) EUROPEAN PATENT APPLICATION
published in accordance with Art. 153(4) EPC

(43) Date of publication:
**02.09.2015 Bulletin 2015/36**

(21) Application number: **13849199.8**

(22) Date of filing: **07.10.2013**

(51) Int Cl.:
***F24J 2/48*** *(2006.01)*

(86) International application number:
**PCT/JP2013/077251**

(87) International publication number:
**WO 2014/065107 (01.05.2014 Gazette 2014/18)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **26.10.2012 JP 2012237314**

(71) Applicant: **Kabushiki Kaisha Toyota Jidoshokki**
**Kariya-shi, Aichi 448-8671 (JP)**

(72) Inventors:
- **TSUTSUI, Takuhito**
**Kariya-shi**
**Aichi 448-8671 (JP)**
- **SASATANI, Toru**
**Kariya-shi**
**Aichi 448-8671 (JP)**
- **NORITAKE, Kazuto**
**Kariya-shi**
**Aichi 448-8671 (JP)**
- **TAKEUCHI, Norihito**
**Kariya-shi**
**Aichi 448-8671 (JP)**

(74) Representative: **Winter, Brandl, Fürniss, Hübner, Röss, Kaiser, Polte - Partnerschaft mbB**
**Patent- und Rechtsanwaltskanzlei**
**Bavariaring 10**
**80336 München (DE)**

# (54) HEAT CONVERSION MEMBER AND HEAT CONVERSION LAMINATE

(57) The present invention addresses the problem of providing a heat conversion member capable of efficiently converting light to heat. This heat conversion member includes at least one type of semiconductor, and is characterized in that the band gap of the semiconductor is 0.5-1.2 eV.

FIG. 2

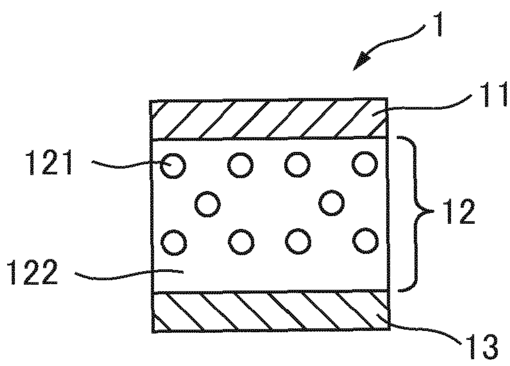


EP 2 913 605 A1

## Description

### Technical Field

The present invention relates to a heat conversion member and to a heat conversion laminate.

### Background Art

Photovoltaic power generation systems are known that convert sunlight to heat and utilize the heat for electric power generation. In the known systems, sunlight is collected with a collector and the collected sunlight is used to heat a heating medium (such as oil, dissolved salts or molten sodium) in a container or flow channel. Provision of covering materials, thin-films and the like on the surfaces of containers or flow channels is also being studied as a way of accelerating heating of the heating medium by the collected sunlight.

For example, PTL 1 proposes a cermet layer (ceramic + metal = cermet) as a member for conversion of sunlight to heat. Also, PTL 2, for example, proposes a solar energy collecting device having one section that receives the action of sunlight rays and another section that is situated at a gap from that section away from sunlight rays and receives the action of a heat absorption medium, and a section situated between the two sections, wherein the absorbing element is made of a covered sheet material, the sheet material having a sunlight ray-selective coating on one side of the sheet facing the section that receives the action of sunlight rays, and having a radiative coating on the other side of the sheet that faces the section that receives the action of the heat absorption medium.

### Citation List

### Patent Literature

[PTL 1] European Patent No. 1397622
[PTL 2] Japanese Unexamined Patent Publication No. 57-55363

## SUMMARY OF INVENTION

### Technical Problem

At the current time, it is desirable to accelerate heating of heating media by collected sunlight and achieve more efficient light-to-heat conversion.

It is an object of the present invention to provide a heat conversion member that can efficiently convert light to heat. It is another object of the present invention to provide a heat conversion laminate comprising a heat conversion member that can efficiently convert light to heat.

### Solution to Problem

The means for achieving these objects is described by the following (1) to (10).

(1) A heat conversion member comprising at least one type of semiconductor,
the band gap of the semiconductor being between 0.5 eV and 1.2 eV.
(2) A heat conversion member comprising a composite material of at least one type of semiconductor and a transparent dielectric material,
the band gap of the semiconductor being between 0.5 eV and 1.2 eV.
(3) The heat conversion member according to (1) or (2) above, wherein the semiconductor comprises $FeS_2$.
(4) The heat conversion member according to (1) or (2) above, wherein the semiconductor comprises $Mg_2Si$.
(5) The heat conversion member according to (1) or (2) above, wherein the semiconductor comprises $Zn_3As_2$.
(6) The heat conversion member according to (1) or (2) above, wherein the semiconductor comprises Ge.
(7) The heat conversion member according to any one of (1) to (6) above, which has a film shape.
(8) The heat conversion member according to (7), wherein the film shape has a thickness of 1 nm to 10 $\mu$m.
(9) A heat conversion laminate having laminated at least one or more layers including the heat conversion member according to (7) or (8), and a metal layer.
(10) A heat conversion laminate having laminated at least a metal layer, one or more layers including the heat conversion member according to (7) or (8), and a transparent dielectric layer, in that order.

Advantageous Effects of Invention

According to the present invention, there is provided a heat conversion member that can efficiently convert light to heat. According to the present invention, there is further provided a heat conversion laminate comprising a heat conversion member that can efficiently convert light to heat.

Brief Description of Drawings

Fig. 1 is a graph showing an optical spectrum for sunlight and an optical spectrum for heat radiant light.
Fig. 2 is a cross-sectional schematic drawing showing a heat conversion laminate 1 as one embodiment of a heat conversion laminate according to the present invention.
Fig. 3 is a graph showing the results for the absorption properties of a Mo-$SiO_2$ cermet monolayer film (calculated).
Fig. 4 is a graph showing the results for the absorption properties of a Mo-$SiO_2$ cermet monolayer film (an actual film).
Fig. 5 is a graph showing the results for the absorption properties of a $FeS_2$-$SiO_2$ cersemi monolayer film.
Fig. 6 is a graph showing the results for the absorption properties of a $Mg_2Si$-$SiO_2$ cersemi monolayer film.
Fig. 7 is a graph showing the results for the absorption properties of a Ge-$SiO_2$ cersemi monolayer film.
Fig. 8 is a graph showing the results for the absorption properties of a $Zn_3As_2$-$SiO_2$ cersemi monolayer film.
Fig. 9 is a graph showing the results for the absorption properties of a Mo-$SiO_2$ cermet monolayer film.
Fig. 10 is a figure showing the laminar structures of $FeS_2$-$SiO_2$ cersemi laminates that operate at a heat collecting temperature of 580°C.
Fig. 11 is a figure showing the laminar structures of $FeS_2$-$SiO_2$ cersemi laminates that operate at a heat collecting temperature of 400°C.
Fig. 12 is a graph showing the results for the absorption properties of a $FeS_2$-$SiO_2$ cersemi laminate and a Mo-$SiO_2$ cermet laminate, that operate at a heat collecting temperature of 580°C.
Fig. 13 is a graph showing the results for the absorption properties of a $FeS_2$-$SiO_2$ cersemi laminate and a Mo-$SiO_2$ cermet laminate, that operate at a heat collecting temperature of 400°C.
Fig. 14 is a graph showing the results for the film efficiency of a $FeS_2$-$SiO_2$ cersemi laminate and a Mo-$SiO_2$ cermet laminate, that operate at a heat collecting temperature of 580°C.
Fig. 15 is a graph showing the results for the film efficiency of a $FeS_2$-$SiO_2$ cersemi laminate and a Mo-$SiO_2$ cermet laminate, that operate at a heat collecting temperature of 400°C.
Fig. 16 is a figure showing the laminar structures of Mo-$SiO_2$ cermet laminates that operate at a heat collecting temperature of 580°C.
Fig. 17 is a figure showing the laminar structures of Mo-$SiO_2$ cermet laminates that operate at a heat collecting temperature of 400°C.

Description of Embodiments

(1) Heat conversion member

The heat conversion member of the present invention is a heat conversion member comprising at least one type of semiconductor, wherein the band gap of the semiconductor is between 0.5 eV and 1.2 eV. The heat conversion member of the present invention is also a heat conversion member comprising a composite material of one or more types of semiconductor and a transparent dielectric material, wherein the band gap of the semiconductor is between 0.5 eV and 1.2 eV. Fig. 1 is a graph showing an optical spectrum for sunlight and an optical spectrum for heat radiant light, and since the heat conversion member of the present invention has a steep change between absorption and non-absorption of sunlight with a wavelength in the range of 2480 nm to 1000 nm (light energy: 0.5 to 1.2 eV), it can efficiently absorb sunlight while minimizing heat release by heat radiation from the heating medium at 200°C to 600°C, and can thus efficiently convert light to heat. If the slope of the absorbance for light is gentle and there is no steep change between absorption and non-absorption in a wavelength range of 2480 nm to 1000 nm, the solar absorbance will be low and the thermal radiation rate will increase, resulting in greater loss of thermal energy.
The one or more semiconductors in the heat conversion member of the present invention may be of a single type of semiconductor, or a mixture of two or more different types of semiconductor.
The semiconductor in the heat conversion member of the present invention is not particularly restricted, and examples include $FeS_2$, $Mg_2Si$, $Zn_3As_2$ and Ge.

The band gap of the one or more types of semiconductor in the heat conversion member of the present invention is between 0.5 eV and 1.2 eV and preferably between 0.7 eV and 1.0 eV.

The transparent dielectric material in the composite material in the heat conversion member of the present invention (hereunder simple referred to as "composite material") is not particularly restricted, and examples include $SiO_2$, $Al_2O_3$ and AlN, with $SiO_2$ being preferred.

The one or more types of semiconductor in the heat conversion member of the present invention preferably include $FeS_2$, $Mg_2Si$, $Zn_3As_2$ or Ge. The values of the band gaps of $FeS_2$, $Mg_2Si$, $Zn_3As_2$ and Ge vary depending on the measuring method and measuring conditions, however generally speaking the value of the $FeS_2$ band gap is 0.95 eV, the value of the $Mg_2Si$ band gap is 0.77 eV, the value of the $Zn_3As_2$ band gap is 0.86 eV and the value of the Ge band gap is 0.89 eV. The one or more types of semiconductor in the heat conversion member of the present invention may also be a mixture of at least two different compounds selected from the group consisting of $FeS_2$, $Mg_2Si$, $Zn_3As_2$ and Ge. The band gap can be measured by a photoabsorption method or photoelectron spectroscopy.

The heat conversion member of the present invention may be in any desired form, such as in the form of a film shape, tube shape, sheet shape or the like, however a film shape is preferred. The thickness of a film of the heat conversion member of the present invention may be any desired thickness so long as the effect of the present invention is exhibited; however, preferably a film of the heat conversion member of the present invention has a thickness of 1 nm to 10 $\mu$m, and more preferably it has a thickness of 5 nm to 100 nm.

The content of the one or more semiconductors in the heat conversion member of the present invention may be as desired, and for example, it may be 10 vol% or greater, 20 vol% or greater, 30 vol% or greater, 40 vol% or greater, 50 vol% or greater, 60 vol% or greater, 70 vol% or greater, 80 vol% or greater, 90 vol% or greater or 95 vol% or greater.

The heat conversion member of the present invention may also essentially consist entirely of the one or more semiconductors, in which case the content of the one or more semiconductors will be 100 vol%.

The heat conversion member of the present invention may also contain any desired material other than the one or more semiconductors. The heat conversion member of the present invention may yet also contain any desired material other than a composite material of the one or more semiconductors and a transparent dielectric material.

The heat conversion member of the present invention can be obtained by any desired publicly known production method. For example, the heat conversion member of the present invention can be produced by physical vapor phase deposition (PVD), sputtering or the like.

(2) Heat conversion laminate

As one feature, the heat conversion laminate of the present invention has laminated one or more layers comprising a film-like heat conversion member of the present invention, and a metal layer, and it may have a metal layer and one or more layers comprising a film-like heat conversion member of the present invention laminated in that order, or the lamination may be in the reverse order.

As another feature, the heat conversion laminate of the present invention also have at least a metal layer, one or more layers comprising a film-like heat conversion member of the present invention and a transparent dielectric layer, laminated in that order.

The one or more layers comprising a film-like heat conversion member of the present invention in the heat conversion laminate of the present invention may be constructed as a photoabsorbing layer, and because it has a steep change between absorption and non-absorption in a sunlight wavelength range of 2480 nm to 1000 nm, it can efficiently absorb sunlight while minimizing heat release by heat radiation from the heating medium at 200°C to 600°C, thereby efficiently convert light to heat. The thickness of the one or more layers comprising a film-like heat conversion member in the heat conversion laminate of the present invention may be any desired thickness so long as the effect of the present invention is exhibited, and it is preferably a thickness of 5 nm to 100 nm. The layer comprising the film-like heat conversion member in the heat conversion laminate of the present invention may be a single layer or multiple layers. The one or more layers comprising a film-like heat conversion member in the heat conversion laminate of the present invention may also include any materials other than the film-like heat conversion member.

The metal layer in the heat conversion laminate of the present invention may be constructed as an infrared anti-reflection layer. The metal layer in the heat conversion laminate of the present invention is not particularly restricted, and for example, it may be a molybdenum (Mo) layer, tungsten (W) layer, silver (Ag) layer, gold (Au) layer, copper (Cu) layer or the like, and is preferably a molybdenum (Mo) layer. The thickness of the metal layer in the heat conversion laminate of the present invention may be any desired thickness so long as the effect of the present invention is exhibited, and it is preferably a thickness of 100 nm or greater.

The transparent dielectric layer in the heat conversion laminate of the present invention may also be constructed as an anti-reflection layer. The transparent dielectric layer in the heat conversion laminate of the present invention is not particularly restricted, and examples include a $SiO_2$ layer, $Al_2O_3$, AlN layer or the like, with a $SiO_2$ layer being preferred. The thickness of the transparent dielectric layer in the heat conversion laminate of the present invention may be any desired thickness so long as the effect of the present invention is exhibited, and it is preferably a thickness of 10 nm to 500 nm.

The heat conversion laminate of the present invention can be obtained by any desired publicly known production method. For example, the heat conversion laminate of the present invention can be produced by physical vapor phase deposition (PVD), sputtering or the like.

The heat conversion laminate of the present invention will now be explained in greater detail with reference to Fig. 2. Incidentally, the heat conversion laminate of the present invention is not limited to the embodiment of the present invention shown in Fig. 2, such as is within the scope of the object and gist of the present invention.

Fig. 2 is a drawing showing a heat conversion laminate 1 as one embodiment of a heat conversion laminate according to an embodiment of the present invention. The heat conversion laminate 1 according to an embodiment of the present invention is formed from a transparent dielectric layer 11, a layer comprising a heat conversion member (photoabsorbing layer) 12, and a metal layer 13. Also, the layer comprising a heat conversion member (photoabsorbing layer) 12 comprises a semiconductor 121 and a transparent dielectric material 122. As shown in Fig. 2, the particles of the semiconductor 121 are dispersed within the transparent dielectric material 122.

Examples

Examples will now be provided for a more concrete explanation of the present invention. The present invention is not limited to these examples, however, provided that the object and gist of the present invention are maintained.

<Verification of reproducibility of film properties according to Bruggeman's effective medium approximation>

The reproducibility of the film properties according to Bruggeman's effective medium approximation was verified by Example 1 and Comparative Example 1.

(Example 1)

The absorption properties of a Mo-$SiO_2$ cermet monolayer film were determined using Bruggeman's theory of computation. The term "cermet" means "ceramic + metal".

The optical constants (n, k) of the Mo-$SiO_2$ cermet monolayer film were calculated by Bruggeman's effective medium approximation formula (formula (1) below). The optical constants for Mo and $SiO_2$ in the Mo-$SiO_2$ cermet were obtained by forming a monolayer film of each component by sputtering, and performing calculation from the measurement data obtained using a spectroscopic ellipsometer, and the reflectance property and the transmittance property as measured with a spectrophotometer.

$$f\frac{(n_S-ik_S)^2-(n-ik)^2}{(n_S-ik_S)^2+2(n-ik)^2}+(1-f)\frac{(n_C-ik_C)^2-(n-ik)^2}{(n_C-ik_C)^2+2(n-ik)^2}=0 \qquad \text{Formula (1)}$$

i: imaginary unit
f: Mo mixing ratio (vol%)
$n_s$, $k_s$: Optical constants of $Mo_3Si$
$n_c$, $k_c$: Optical constants of $SiO_2$

A multilayer film approximation based on the optical constants (n, k) for Mo-$SiO_2$ cermet obtained by calculation based on formula (1) was used to calculate the absorbance of the Mo-$SiO_2$ cermet monolayer film (corresponding to a film thickness of 30 nm). The results for the absorption properties of a Mo-$SiO_2$ cermet monolayer film (calculated) are shown in Fig. 3.

(Comparative Example 1)

The absorption properties of a Mo-$SiO_2$ cermet monolayer film were determined using an actual film (prepared film).

A film was formed by simultaneous sputtering of Mo and $SiO_2$ on a quartz substrate that had been heated to a temperature of 500°C to 600°C, to obtain a sample of a Mo-$SiO_2$ cermet monolayer film. The optical constants (refractive index n, extinction coefficient k) of the Mo-$SiO_2$ cermet were calculated for the obtained sample from the measurement data with a spectroscopic ellipsometer and the reflectance property and transmittance property measured with a spectrophotometer.

The calculated multilayer film approximation based on the optical constants (n, k) for Mo-$SiO_2$ cermet was used to calculate the absorbance of the Mo-$SiO_2$ cermet monolayer film (corresponding to a film thickness of 30 nm). The results for the absorption properties of the Mo-$SiO_2$ cermet monolayer film (an actual film) are shown in Fig. 4.

<Verification results>

As is clear by referring to Fig. 3 and Fig. 4, it was verified that the results for the absorption properties based on Bruggeman's theory of computation (Fig. 3) reasonably equated with the results for the absorption properties of the actual film (prepared film) (Fig. 4).

<Evaluation of absorption properties of heat conversion member>

The absorption properties of a heat conversion member were evaluated using Example 2 and Comparative Example 2.

(Example 2)

Evaluation of the absorption properties of a heat conversion member of the present invention was conducted using a $FeS_2$-$SiO_2$ cersemi monolayer film, a $Mg_2Si$-$SiO_2$ cersemi monolayer film, a Ge-$SiO_2$ cersemi monolayer film and a $Zn_3As_2$-$SiO_2$ cersemi monolayer film. The term "cersemi" means "ceramic + semiconductor".

The optical constants (n, k) of the $FeS_2$-$SiO_2$ cersemi, $Mg_2Si$-$SiO_2$ cersemi, Ge-$SiO_2$ cersemi and $Zn_3As_2$-$SiO_2$ cersemi were calculated by Bruggeman's effective medium approximation formula (formula (2) below). For the optical constants ($n_s$, $k_s$) for $FeS_2$, Ge and $Zn_3As_2$, refer to "Handbook of Optical Constants of Solids", Edward D. Palik, Academic Press, Boston, 1985", and for the optical constants ($n_s$, $k_s$) of $Mg_2Si$, refer to "T. Kato et al., J. Appl. Phys. 110, 063723(2011)". Experimental data were used for the optical constants ($n_c$, $k_c$) of $SiO_2$.

$$f\frac{(n_S-ik_S)^2-(n-ik)^2}{(n_S-ik_S)^2+2(n-ik)^2}+(1-f)\frac{(n_C-ik_C)^2-(n-ik)^2}{(n_C-ik_C)^2+2(n-ik)^2}=0 \qquad \text{Formula (2)}$$

i: imaginary unit
f: Semiconductor mixing ratio (vol%)
$n_s$, $k_s$: Optical constants of semiconductor
$n_c$, $k_c$: Optical constants of $SiO_2$

Using the multilayer film approximations based on the optical constants (n, k) for $FeS_2$-$SiO_2$ cersemi, $Mg_2Si$-$SiO_2$ cersemi, Ge-$SiO_2$ cersemi and $Zn_3As_2$-$SiO_2$ cersemi, obtained by each calculation using formula (2), each absorbance was calculated for the $FeS_2$-$SiO_2$ cersemi monolayer film, $Mg_2Si$-$SiO_2$ cersemi monolayer film, Ge-$SiO_2$ cersemi monolayer film and $Zn_3As_2$-$SiO_2$ cersemi monolayer film (corresponding to a film thickness of 30 nm). Fig. 5 to Fig. 8 show the results for the absorption properties of a $FeS_2$-$SiO_2$ cersemi monolayer film, $Mg_2Si$-$SiO_2$ cersemi monolayer film, Ge-$SiO_2$ cersemi monolayer film and $Zn_3As_2$-$SiO_2$ cersemi monolayer film.

(Comparative Example 2)

The absorption properties of a Mo-$SiO_2$ cermet monolayer film were evaluated.

The optical constant (n, k) of the Mo-$SiO_2$ cermet monolayer film was calculated by Bruggeman's effective medium approximation formula (formula (1) below). The optical constants for Mo and $SiO_2$ in the Mo-$SiO_2$ cermet were obtained by forming a monolayer film of each component by sputtering, and performing calculation from the measurement data obtained using a spectroscopic ellipsometer, and the reflectance property and the transmittance property as measured with a spectrophotometer.

$$f\frac{(n_S-ik_S)^2-(n-ik)^2}{(n_S-ik_S)^2+2(n-ik)^2}+(1-f)\frac{(n_C-ik_C)^2-(n-ik)^2}{(n_C-ik_C)^2+2(n-ik)^2}=0 \qquad \text{Formula (1)}$$

i: imaginary unit
f: Mo mixing ratio (vol%)
$n_s$, $k_s$: Optical constants of $Mo_3Si$
$n_c$, $k_c$: Optical constants of $SiO_2$

A multilayer film approximation based on the optical constants (n, k) for Mo-$SiO_2$ cermet obtained by calculation based on formula (1) was used to calculate the absorbance of the Mo-$SiO_2$ cermet monolayer film (corresponding to a film thickness of 30 nm). The results for the absorption properties of the Mo-$SiO_2$ cermet monolayer film are shown in Fig. 9.

<Evaluation results>

Referring to Fig. 5 to Fig. 8 and Fig. 9, the results for the absorption properties of the Mo-$SiO_2$ cermet monolayer film (Fig. 9) show a gentle slope for the absorbance of light in a wavelength range of 2480 to 1000 nm, whereas the results for the absorption properties of the $FeS_2$-$SiO_2$ cersemi monolayer film, $Mg_2Si$-$SiO_2$ cersemi monolayer film, Ge-$SiO_2$ cersemi monolayer film and $Zn_3As_2$-$SiO_2$ cersemi monolayer film (Fig. 5 to Fig. 8) show an abrupt slope for the absorbance of light in a wavelength range of 2480 to 1000 nm, by which it is seen that the $FeS_2$-$SiO_2$ cersemi monolayer film, $Mg_2Si$-$SiO_2$ cersemi monolayer film, Ge-$SiO_2$ cersemi monolayer film and $Zn_3As_2$-$SiO_2$ cersemi monolayer film efficiently absorb sunlight while minimizing heat release by heat radiation from the heating medium at 200°C to 600°C.

<Evaluation of absorption property of heat conversion laminate and evaluation of film efficiency>

Evaluation of the absorption properties of a heat conversion laminate and evaluation of the film efficiency were conducted using Example 3 and Comparative Example 3.

(Example 3)

Evaluation of the absorption properties of a heat conversion laminate of the present invention and evaluation of the film efficiency were conducted using a $FeS_2$-$SiO_2$ cersemi laminate. The structure of the $FeS_2$-$SiO_2$ cersemi laminate that operates at a heat collecting temperature of 580°C was a 4-layer structure comprising a $SiO_2$ layer (film thickness: 70 nm), a cersemi layer with a $FeS_2$ mixing ratio of 30% (film thickness: 70 nm), a cersemi layer with a $FeS_2$ mixing ratio of 100% (film thickness: 15 nm) and a Mo (molybdenum) layer (film thickness: 100 nm) from the light incident side, as shown in Fig. 10. The structure of the $FeS_2$-$SiO_2$ cersemi laminate that operates at a heat collecting temperature of 400°C was a 4-layer structure comprising a $SiO_2$ layer (film thickness: 80 nm), a cersemi layer with a $FeS_2$ mixing ratio of 30% (film thickness: 75 nm), a cersemi layer with a $FeS_2$ mixing ratio of 100% (film thickness: 25 nm) and a Mo (molybdenum) layer (film thickness: 100 nm) from the light incident side, as shown in Fig. 11. The film structures ($FeS_2$ mixing ratio and film thickness) for the $FeS_2$-$SiO_2$ cersemi laminate that operates at a heat collecting temperature of 580°C and the $FeS_2$-$SiO_2$ cersemi laminate that operates at a heat collecting temperature of 400°C, were set so as to exhibit the maximum film efficiency, as described below.

The optical constants (n, k) of the $FeS_2$-$SiO_2$ cersemi layers of the $FeS_2$-$SiO_2$ cersemi laminate that operates at a heat collecting temperature of 580°C and the $FeS_2$-$SiO_2$ cersemi laminate that operates at a heat collecting temperature of 400°C were determined by exactly the same calculation method as used for the optical constants (n, k) of Example 2. For the optical constants (n, k) of Mo, refer to "Handbook of Optical Constants of Solids", Edward D. Palik, Academic Press, Boston, 1985". Experimental data were used for the optical constants ($n_c$, $k_c$) of $SiO_2$.

The absorbance of the $FeS_2$-$SiO_2$ cersemi laminate that operates at a heat collecting temperature of 580°C was calculated using multilayer film approximation, based on the optical constants ($n_c$, $k_c$) of the $SiO_2$ layer (film thickness: 70 nm), the optical constants (n, k) of the cersemi layer with a $FeS_2$ mixing ratio of 30% (film thickness: 70 nm), the optical constants (n, k) of the cersemi layer with a $FeS_2$ mixing ratio of 100% (film thickness: 15 nm) and the optical constants (n, k) of the Mo (molybdenum) layer (film thickness: 100 nm). The results for the absorption properties of the $FeS_2$-$SiO_2$ cersemi laminate that operates at a heat collecting temperature of 580°C are shown in Fig. 12.

Similarly, the absorbance of the $FeS_2$-$SiO_2$ cersemi laminate that operates at a heat collecting temperature of 400°C was calculated using multilayer film approximation, based on the optical constants ($n_c$, $k_c$) of the $SiO_2$ layer (film thickness: 80 nm), the optical constants (n, k) of the cersemi layer with a $FeS_2$ mixing ratio of 30% (film thickness: 75 nm), the optical constants (n, k) of the cersemi layer with a $FeS_2$ mixing ratio of 100% (film thickness: 25 nm) and the optical constants (n, k) of the Mo (molybdenum) layer (film thickness: 100 nm). The results for the absorption properties of the $FeS_2$-$SiO_2$ cersemi laminate that operates at a heat collecting temperature of 400°C are shown in Fig. 13.

Next, the values of the film efficiency $\eta$ for the $FeS_2$-$SiO_2$ cersemi laminate that operates at a heat collecting temperature of 580°C and the $FeS_2$-$SiO_2$ cersemi laminate that operates at a heat collecting temperature of 400°C, were determined by formula (3) below. The film efficiency $\eta$ is an index representing the function of sunlight to heat

conversion.

$$\eta = \alpha - \frac{\sigma T^4}{CI}\varepsilon \qquad \text{Formula (3)}$$

α: Solar absorbance
ε: Thermal radiation rate
σ: Stefan-Boltzmann constant
T: Absolute temperature
C: Amount of solar collection
I: Total solar energy, calculated from AM1.5 (solar intensity data based on ASTM)

The results for the film efficiency η of the $FeS_2$-$SiO_2$ cersemi laminate that operates at a heat collecting temperature of 580°C are shown in Fig. 14. The results for the film efficiency η of the $FeS_2$-$SiO_2$ cersemi laminate that operates at a heat collecting temperature of 400°C are shown in Fig. 15.

(Comparative Example 3)

The absorption property of a Mo-$SiO_2$ cermet laminate and the film efficiency were evaluated. The structure of a Mo-$SiO_2$ cermet laminate that operates at a heat collecting temperature of 580°C was a 4-layer structure comprising a $SiO_2$ layer (film thickness: 80 nm), a cermet layer film with a Mo mixing ratio of 40% (film thickness: 40 nm), a cermet layer with a Mo mixing ratio of 50% (film thickness: 25 nm) and a Mo (molybdenum) layer (film thickness: 100 nm), from the light incident side, as shown in Fig. 16. The structure of a Mo-$SiO_2$ cermet laminate that operates at a heat collecting temperature of 400°C was a 4-layer structure comprising a $SiO_2$ layer (film thickness: 90 nm), a cermet layer film with a Mo mixing ratio of 30% (film thickness: 50 nm), a cermet layer with a Mo mixing ratio of 50% (film thickness: 50 nm) and a Mo (molybdenum) layer (film thickness: 100 nm), from the light incident side, as shown in Fig. 17. The film structures ($FeS_2$ mixing ratio and film thickness) for the Mo-$SiO_2$ cermet laminate that operates at a heat collecting temperature of 580°C and the Mo-$SiO_2$ cermet laminate that operates at a heat collecting temperature of 400°C, were set so as to exhibit the maximum film efficiency, as described below.
The optical constants (n, k) of the Mo-$SiO_2$ cermet layers of the Mo-$SiO_2$ cermet laminate that operates at a heat collecting temperature of 580°C and the Mo-$SiO_2$ cermet laminate that operates at a heat collecting temperature of 400°C were determined by the same calculation method as used for the optical constants (n, k) of Comparative Example 2. For the optical constants (n, k) of Mo, refer to "Handbook of Optical Constants of Solids", Edward D. Palik, Academic Press, Boston, 1985". Experimental data were used for the optical constants ($n_c$, $k_c$) of $SiO_2$.
The absorbance of the Mo-$SiO_2$ cermet laminate that operates at a heat collecting temperature of 580°C was calculated using multilayer film approximation, based on the optical constants ($n_c$, $k_c$) of a $SiO_2$ layer (film thickness: 80 nm), the optical constants (n, k) of a cermet layer with a Mo mixing ratio of 40% (film thickness: 40 nm), the optical constants (n, k) of a cermet layer with a Mo mixing ratio of 50% (film thickness: 25 nm) and the optical constants (n, k) of a Mo (molybdenum) layer (film thickness: 100 nm). The results for the absorption properties of the Mo-$SiO_2$ cermet laminate that operates at a heat collecting temperature of 580°C are shown in Fig. 12.
Similarly, the absorbance of the Mo-$SiO_2$ cermet laminate that operates at a heat collecting temperature of 400°C was calculated using multilayer film approximation, based on the optical constants ($n_c$, $k_c$) of a $SiO_2$ layer (film thickness: 90 nm), the optical constants (n, k) of a cermet layer with a Mo mixing ratio of 30% (film thickness: 50 nm), the optical constants (n, k) of a cermet layer with a Mo mixing ratio of 50% (film thickness: 50 nm) and the optical constants (n, k) of a Mo (molybdenum) layer (film thickness: 100 nm). The results for the absorption properties of the Mo-$SiO_2$ cermet laminate that operates at a heat collecting temperature of 400°C are shown in Fig. 13.
Next, the values of the film efficiency η for the Mo-$SiO_2$ cermet laminate that operates at a heat collecting temperature of 580°C and the Mo-$SiO_2$ cermet laminate that operates at a heat collecting temperature of 400°C, were determined by formula (3) below.

$$\eta = \alpha - \frac{\sigma T^4}{CI}\varepsilon \qquad \text{Formula (3)}$$

α: Solar absorbance
ε: Thermal radiation rate
σ: Stefan-Boltzmann constant

T: Absolute temperature
C: Amount of solar collection
I: Total solar energy, calculated from AM1.5 (solar intensity data based on ASTM)

The results for the film efficiency η of the Mo-$SiO_2$ cermet laminate that operates at a heat collecting temperature of 580°C are shown in Fig. 14. The results for the film efficiency η of the Mo-$SiO_2$ cermet laminate that operates at a heat collecting temperature of 400°C are shown in Fig. 15.

<Evaluation results>

Referring to Fig. 12 and Fig. 13, the results for the absorption properties of Mo-$SiO_2$ cermet laminates, that operate at a heat collecting temperature of 580°C and that operate at a heat collecting temperature of 400°C, indicate that the slope of the absorbance for light in a wavelength range of 2480 to 1000 nm is gentle, while the results for the absorption properties of the $FeS_2$-$SiO_2$ cersemi laminate indicate that the slope of the absorbance for light in a wavelength range of 2480 to 1000 nm is abrupt, thus demonstrating that a $FeS_2$-$SiO_2$ cersemi laminate efficiently absorbs sunlight while minimizing heat release due to heat radiation from the heating medium at 200°C to 600°C. Referring to Fig. 14, the film efficiency η of the Mo-$SiO_2$ cermet laminate that operates at a heat collecting temperature of 580°C was 82.6%, while the film efficiency η of the $FeS_2$-$SiO_2$ cersemi laminate was 84.5%, and therefore the film efficiency η of the $FeS_2$-$SiO_2$ cersemi laminate was superior to the film efficiency η of the Mo-$SiO_2$ cermet laminate. Referring to Fig. 15, the film efficiency η of the Mo-$SiO_2$ cermet laminate that operates at a heat collecting temperature of 400°C was 90.5%, while the film efficiency η of the $FeS_2$-$SiO_2$ cersemi laminate was 90.3%, and therefore the film efficiency η of the $FeS_2$-$SiO_2$ cersemi laminate and the film efficiency η of the Mo-$SiO_2$ cermet laminate were on the same level.

Reference Signs List

1 Heat conversion laminate
11 Transparent dielectric layer
12 Layer comprising heat conversion member (photoabsorbing layer)
13 Metal layer
121 Semiconductor
122 Transparent dielectric material

## Claims

**1.** A heat conversion member comprising one or more types of semiconductor,
the band gap of the semiconductor being between 0.5 eV and 1.2 eV.

**2.** A heat conversion member comprising a composite material of at least one type of semiconductor and a transparent dielectric material,
the band gap of the semiconductor being between 0.5 eV and 1.2 eV.

**3.** The heat conversion member according to claim 1 or 2, wherein the semiconductor comprises $FeS_2$.

**4.** The heat conversion member according to claim 1 or 2, wherein the semiconductor comprises $Mg_2Si$.

**5.** The heat conversion member according to claim 1 or 2, wherein the semiconductor comprises $Zn_3As_2$.

**6.** The heat conversion member according to claim 1 or 2, wherein the semiconductor comprises Ge.

**7.** The heat conversion member according to any one of claims 1 to 6, which has a film shape.

**8.** The heat conversion member according to claim 7, wherein the film shape has a thickness of 1 nm to 10 μm.

**9.** A heat conversion laminate having laminated at least one or more layers including the heat conversion member according to claim 7 or 8, and a metal layer.

**10.** A heat conversion laminate having laminated at least a metal layer, one or more layers including the heat conversion member according to claim 7 or 8, and a transparent dielectric layer, in that order.

**Amended claims under Art. 19.1 PCT**

**1.** A light-to-heat conversion member comprising a composite material of one or more kinds of semiconductor and a transparent dielectric material,
the band gap of the semiconductor being between 0.5 eV and 1.2 eV.

**2.** The light-to-heat conversion member according to claim 1, wherein the semiconductor comprises $FeS_2$.

**3.** The light-to-heat conversion member according to claim 1, wherein the semiconductor comprises $Mg_2Si$.

**4.** The light-to-heat conversion member according to claim 1, wherein the semiconductor comprises $Zn_3As_2$.

**5.** The light-to-heat conversion member according to claim 1, wherein the semiconductor comprises Ge.

**6.** The light-to-heat conversion member according to any one of claims 1 to 5, which has a film shape.

**7.** The light-to-heat conversion member according to claim 6, wherein the film shape has a thickness of 1 nm to 10 $\mu$m.

**8.** A light-to-heat conversion laminate having laminated at least one or more layers including the light-to-heat conversion member according to claim 6 or 7, and a metal layer.

**9.** A light-to-heat conversion laminate having laminated at least a metal layer, one or more layers including the light-to-heat conversion member according to claim 6 or 7, and a transparent dielectric layer, in that order.

FIG. 1

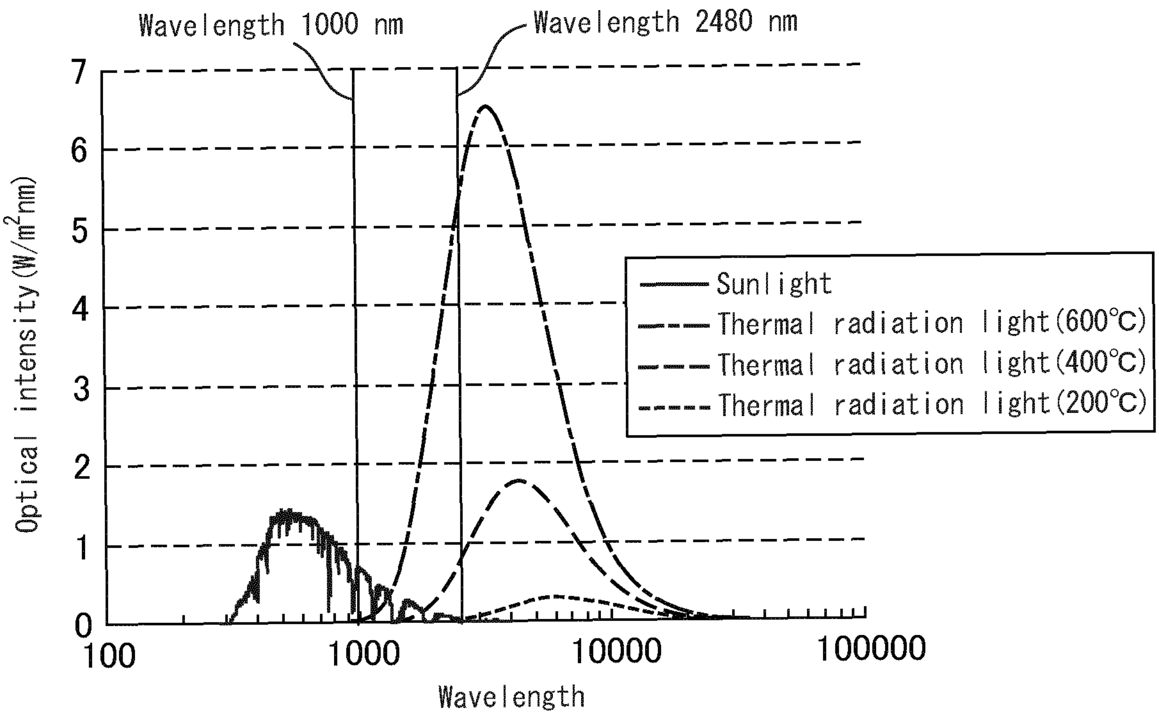
Wavelength 1000 nm
Wavelength 2480 nm
7
6
5
4
3
2
1
0
100
1000
10000
100000
Optical intensity (W/m2nm)
Wavelength
Sunlight
Thermal radiation light(600°C)
Thermal radiation light(400°C)
Thermal radiation light(200°C)

FIG. 2

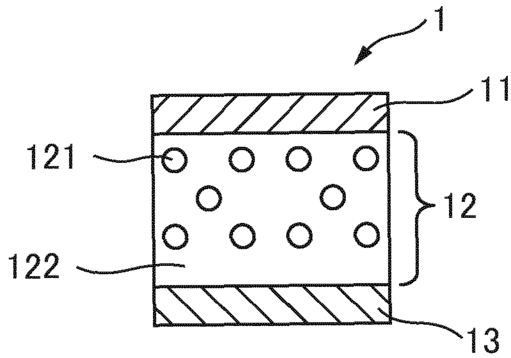
1
11
121
12
122
13

FIG. 3

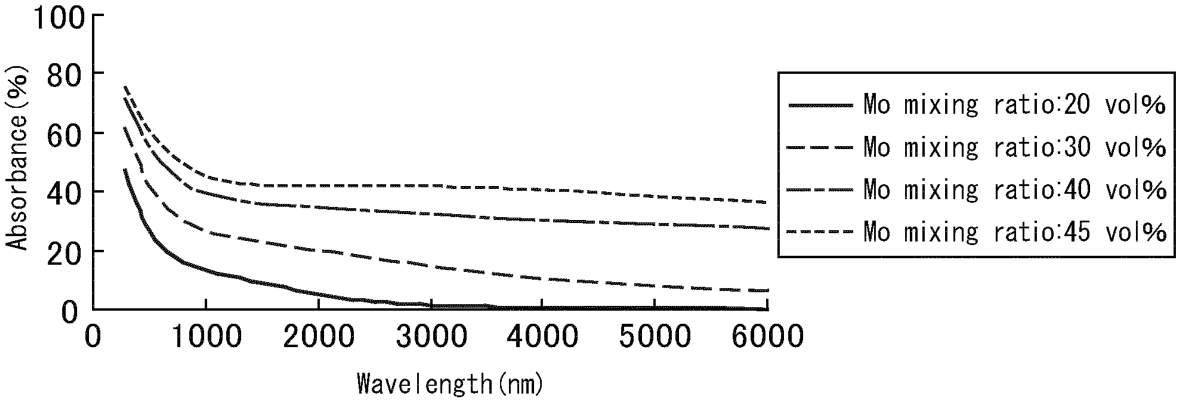
100
80
60
40
20
0
Absorbance (%)
0
1000
2000
3000
4000
5000
6000
Wavelength (nm)
Mo mixing ratio:20 vol%
Mo mixing ratio:30 vol%
Mo mixing ratio:40 vol%
Mo mixing ratio:45 vol%

FIG. 4

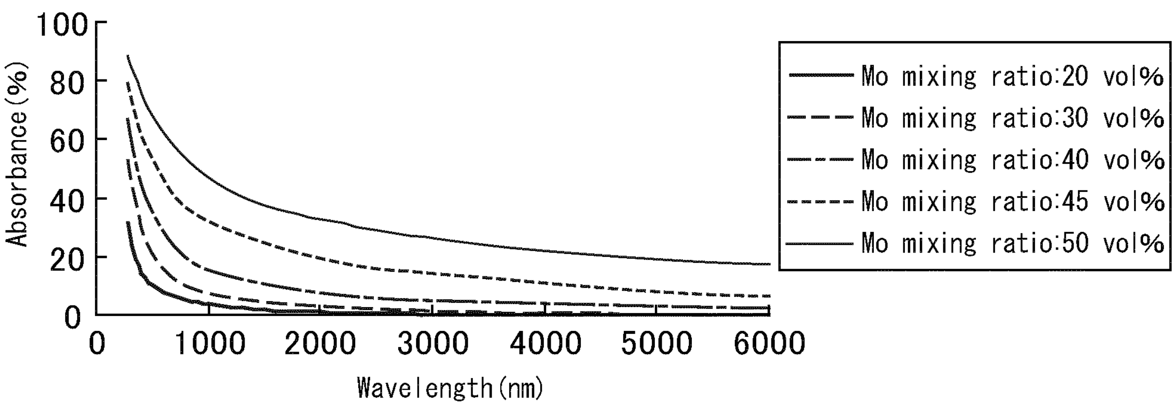
100
80
60
40
20
0
Absorbance (%)
0
1000
2000
3000
4000
5000
6000
Wavelength (nm)
Mo mixing ratio:20 vol%
Mo mixing ratio:30 vol%
Mo mixing ratio:40 vol%
Mo mixing ratio:45 vol%
Mo mixing ratio:50 vol%

FIG. 5

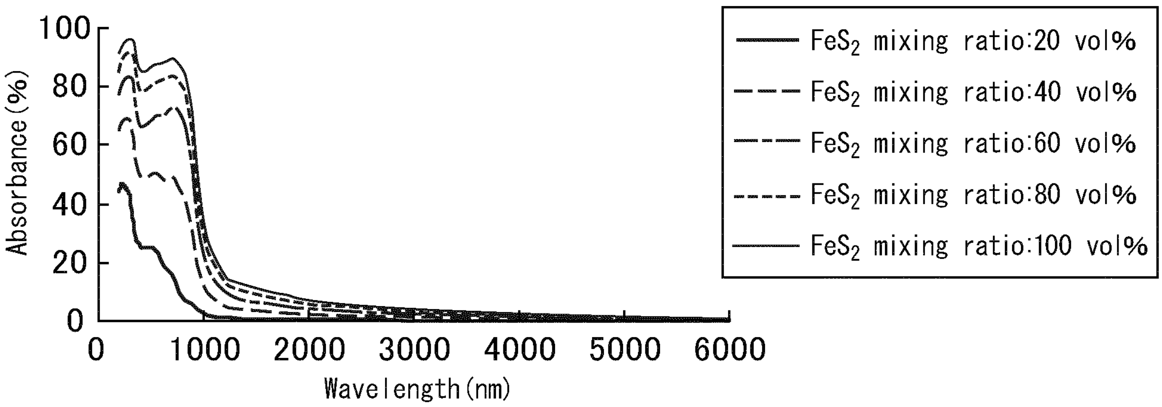
100
80
60
40
20
0
Absorbance (%)
0
1000
2000
3000
4000
5000
6000
Wavelength (nm)
FeS2 mixing ratio:20 vol%
FeS2 mixing ratio:40 vol%
FeS2 mixing ratio:60 vol%
FeS2 mixing ratio:80 vol%
FeS2 mixing ratio:100 vol%

FIG. 6

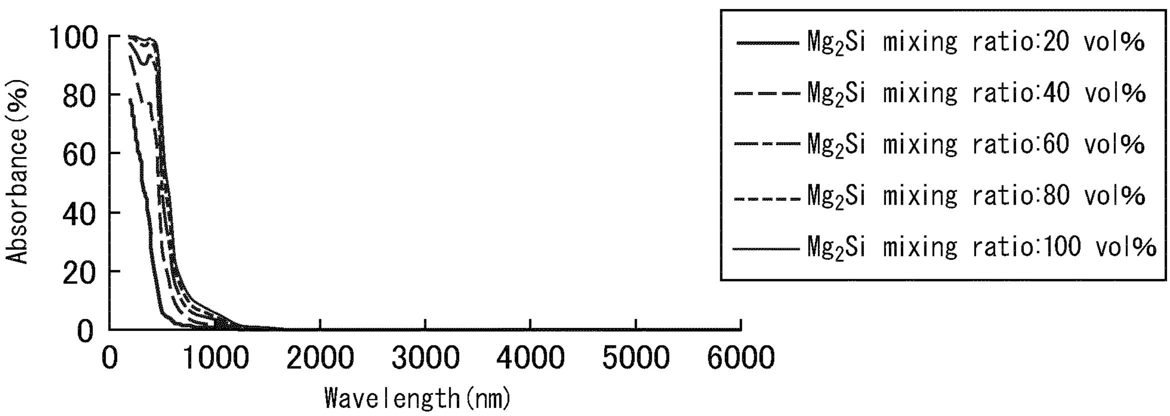
100
80
60
40
20
0
Absorbance (%)
0
1000
2000
3000
4000
5000
6000
Wavelength (nm)
Mg2Si mixing ratio:20 vol%
Mg2Si mixing ratio:40 vol%
Mg2Si mixing ratio:60 vol%
Mg2Si mixing ratio:80 vol%
Mg2Si mixing ratio:100 vol%

FIG. 7

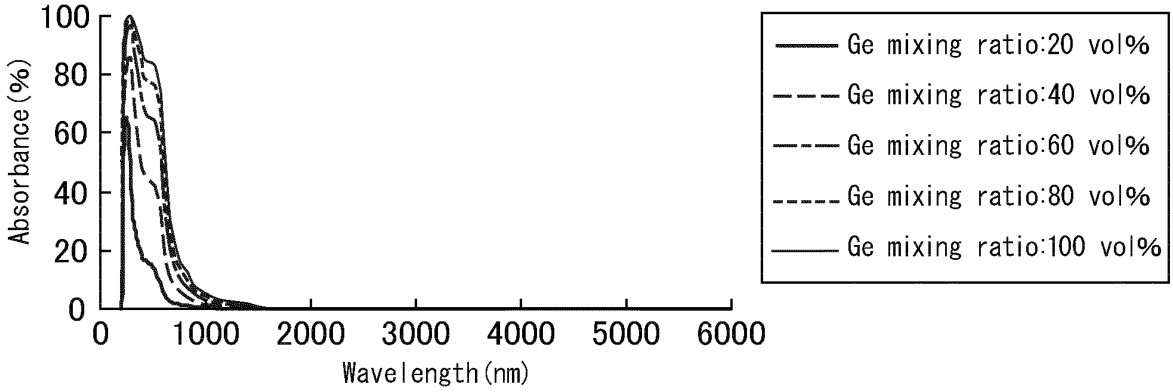
100
80
60
40
20
0
Absorbance (%)
0
1000
2000
3000
4000
5000
6000
Wavelength (nm)
Ge mixing ratio:20 vol%
Ge mixing ratio:40 vol%
Ge mixing ratio:60 vol%
Ge mixing ratio:80 vol%
Ge mixing ratio:100 vol%

FIG. 8

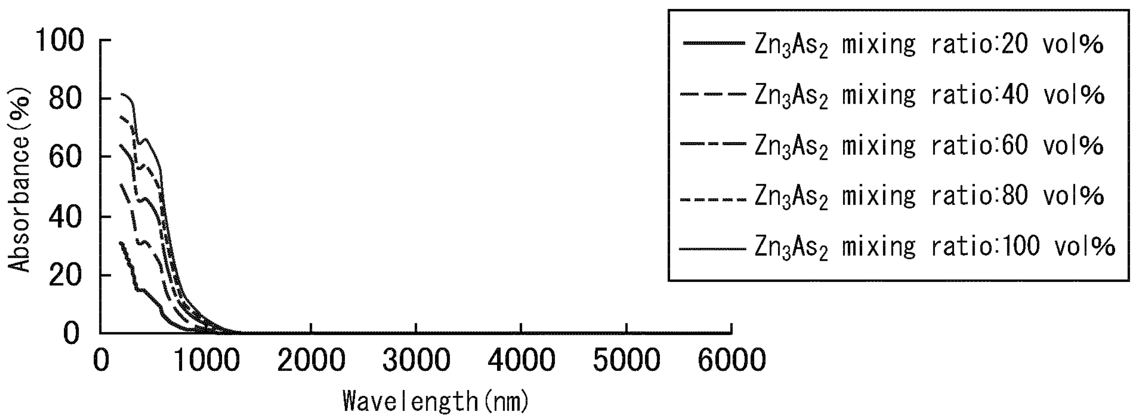
100
80
60
40
20
0
Absorbance (%)
0
1000
2000
3000
4000
5000
6000
Wavelength (nm)
$Zn_3As_2$ mixing ratio:20 vol%
$Zn_3As_2$ mixing ratio:40 vol%
$Zn_3As_2$ mixing ratio:60 vol%
$Zn_3As_2$ mixing ratio:80 vol%
$Zn_3As_2$ mixing ratio:100 vol%

FIG. 9

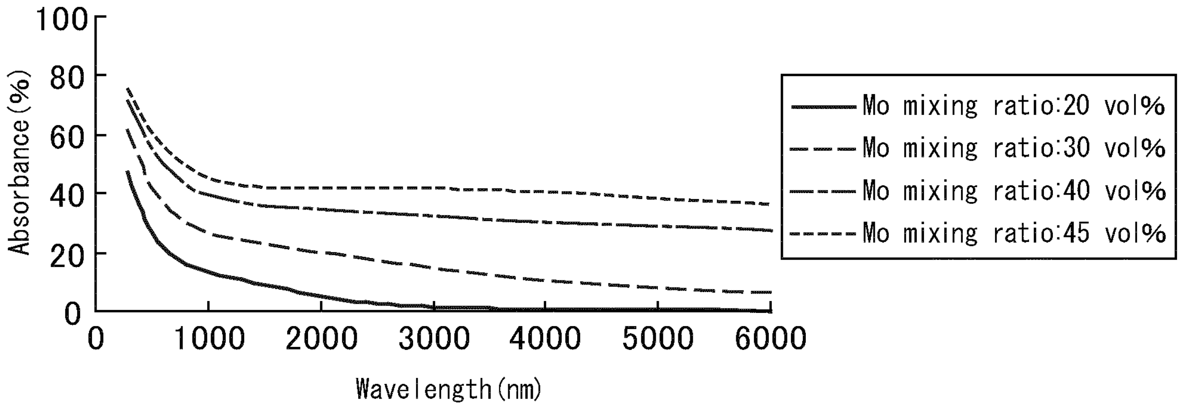


FIG. 10

| |
|---|
| $SiO_2$ layer, film thickness:70 nm |
| $FeS_2$ cersemi layer, $FeS_2$ mixing ratio:30%, film thickness:70 nm |
| $FeS_2$ cersemi layer, $FeS_2$ mixing ratio:100%, film thickness:15 nm |
| Mo layer, film thickness:100 nm |

FIG. 11

| |
|---|
| $SiO_2$ layer, film thickness:80 nm |
| $FeS_2$ cersemi layer, $FeS_2$ mixing ratio:30%, film thickness:75 nm |
| $FeS_2$ cersemi layer, $FeS_2$ mixing ratio:100%, film thickness:25 nm |
| Mo layer, film thickness:100 nm |

FIG. 12

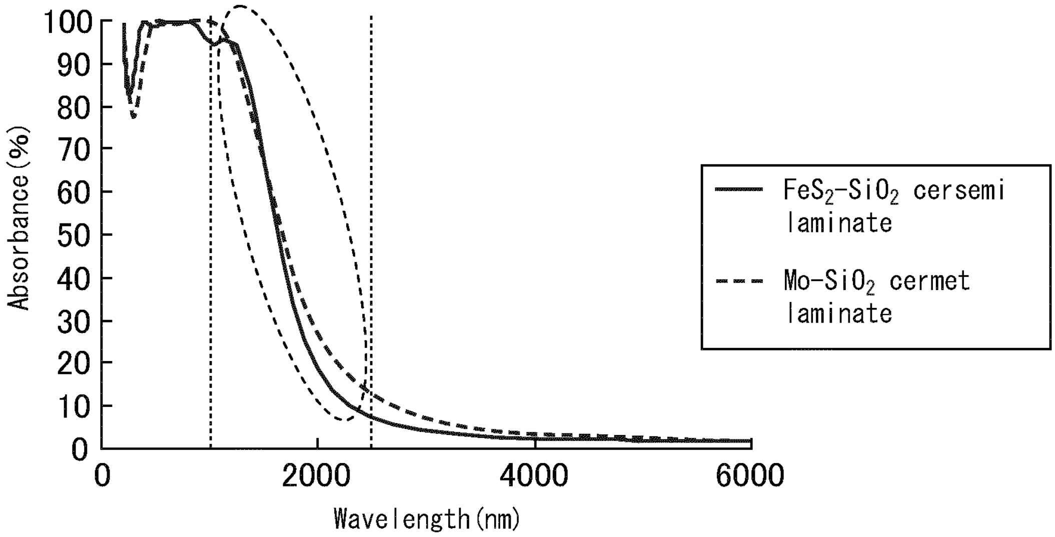
100
90
80
70
60
50
40
30
20
10
0
Absorbance (%)
0
2000
4000
6000
Wavelength (nm)
$FeS_2$-$SiO_2$ cersemi laminate
Mo-$SiO_2$ cermet laminate

FIG. 13

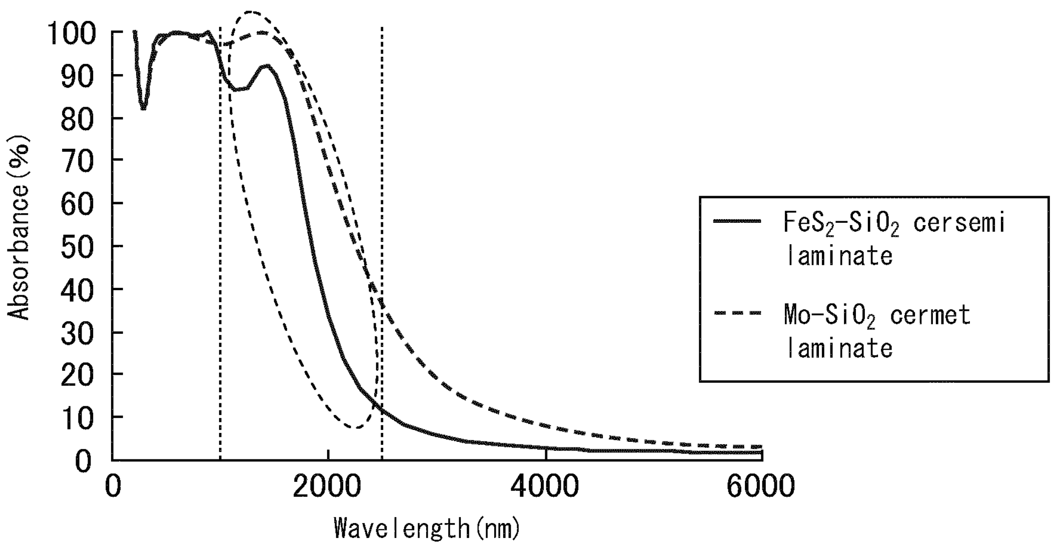
100
90
80
70
60
50
40
30
20
10
0
Absorbance (%)
0
2000
4000
6000
Wavelength (nm)
$FeS_2$-$SiO_2$ cersemi laminate
Mo-$SiO_2$ cermet laminate

FIG. 14

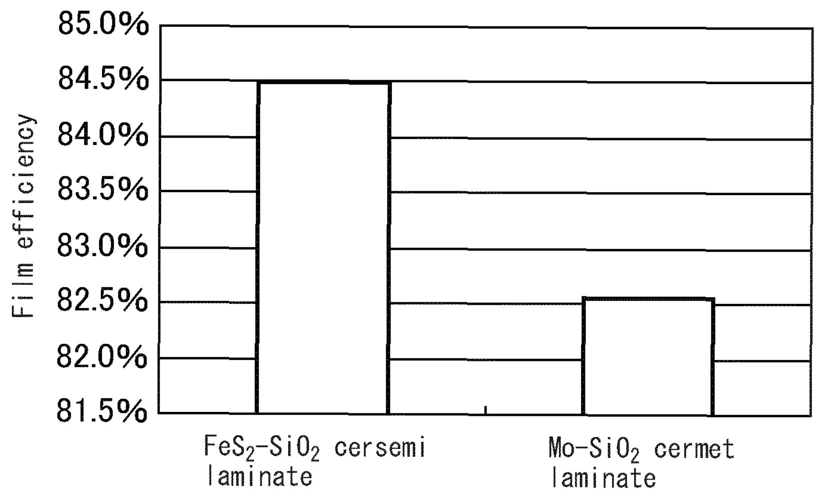
85.0%
84.5%
84.0%
83.5%
83.0%
82.5%
82.0%
81.5%
Film efficiency
FeS2-SiO2 cersemi laminate
Mo-SiO2 cermet laminate

FIG. 15

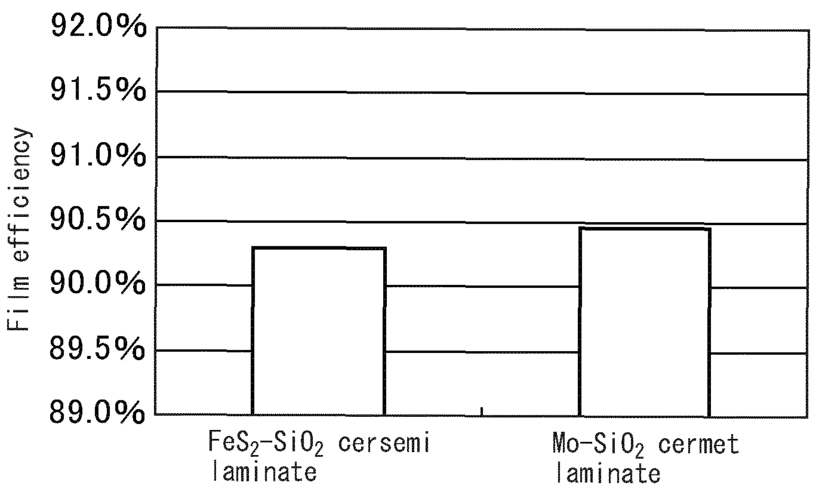
92.0%
91.5%
91.0%
90.5%
90.0%
89.5%
89.0%
Film efficiency
FeS2-SiO2 cersemi laminate
Mo-SiO2 cermet laminate

FIG. 16

| |
|---|
| $SiO_2$ layer, film thickness: 80 nm |
| Mo cermet layer, Mo mixing ratio: 40%, film thickness: 40 nm |
| Mo cermet layer, Mo mixing ratio: 50%, film thickness: 25 nm |
| Mo layer, film thickness: 100 nm |

FIG. 17

| |
|---|
| $SiO_2$ layer, film thickness: 90 nm |
| Mo cermet layer, Mo mixing ratio: 30%, film thickness: 50 nm |
| Mo cermet layer, Mo mixing ratio: 50%, film thickness: 50 nm |
| Mo layer, film thickness: 100 nm |

**INTERNATIONAL SEARCH REPORT**

International application No. PCT/JP2013/077251

A. CLASSIFICATION OF SUBJECT MATTER
*F24J2/48*(2006.01)i

According to International Patent Classification (IPC) or to both national classification and IPC

B. FIELDS SEARCHED

Minimum documentation searched (classification system followed by classification symbols)
F24J2/48

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 4-32301 B2 (Mitsubishi Electric Corp.), 28 May 1992 (28.05.1992), page 1, column 2, line 11 to page 2, column 3, line 7 (Family: none) | 1,7,9<br>2-6,8,10 |
| X<br>Y | JP 3-79957 A (ULVAC Japan Ltd.), 04 April 1991 (04.04.1991), page 1, lower left column, line 17 to page 2, upper left column, line 5 (Family: none) | 1,6-7<br>2-5,8-10 |
| X<br>Y | JP 2006-229168 A (Seiko Epson Corp.), 31 August 2006 (31.08.2006), paragraphs [0028] to [0038]; fig. 1 (Family: none) | 1,7-8<br>2-6,9-10 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 18 December, 2013 (18.12.13) | 07 January, 2014 (07.01.14) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2013/077251

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2010-2077 A (Sharp Corp.), 07 January 2010 (07.01.2010), paragraphs [0027] to [0049]; fig. 1 to 2 (Family: none) | 2-10 |
| P,A | JP 2013-104617 A (Toyota Motor Corp.), 30 May 2013 (30.05.2013), entire text; all drawings & WO 2013/072731 A2 | 1-10 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 1397622 A
- JP 57055363 A


### Non-patent literature cited in the description


- **EDWARD D. PALIK.** Handbook of Optical Constants of Solids. Academic Press, 1985
- **T. KATO et al.** *J. Appl. Phys.,* 2011, vol. 110, 063723